# EUROPÄISCHE PATENTANMELDUNG

(11) **EP 1 903 622 A2**
(43) Veröffentlichungstag der Anmeldung: **26.03.2008**
(21) Anmeldenummer: 07018312.4
(22) Anmeldetag: 18.09.2007
(51) Int. Cl.: H01L 41/107

(54) **Piezotransformator**

(30) Priorität: 20.09.2006 DE 102006044185
(71) Anmelder: EPCOS AG, 81669 München (DE)
(72) Erfinder: Kartashev, Igor, Dr., 8530 Deutschlandsberg (AT); Rauch, Wolfgang, 8530 Deutschlandsberg (AT)
(74) Vertreter: Epping - Hermann - Fischer

(57) **Zusammenfassung**

Es wird ein Piezotransformator mit einem Körper (1) angegeben, der einen Eingangsteil (2), einen Ausgangsteil (3) und ein zwischen diesen angeordnetes Isolierteil (4) umfasst. Das Isolierteil (4) weist eine erste Vertiefung auf, in der der Eingangsteil (2) angeordnet ist, und eine zweite Vertiefung, in der der Ausgangsteil (3) angeordnet ist.

## Beschreibung

Ein Piezotransformator ist aus der Druckschrift JP 2000-091660 A bekannt. Ein Piezotransformator weist einen Eingangsteil und einen Ausgangsteil auf, die mechanisch miteinander verkoppelt sind.

Eine zu lösende Aufgabe besteht darin, einen Piezotransformator anzugeben, der eine hohe Durchschlagsfestigkeit aufweist.

Es wird ein Piezotransformator mit einem Körper angegeben, der einen Eingangsteil, einen Ausgangsteil und ein Isolierteil umfasst, das den Eingangsteil und den Ausgangsteil mechanisch miteinander verbindet. Das Isolierteil weist eine erste Vertiefung zur Aufnahme des Eingangsteils und eine zweite Vertiefung zur Aufnahme des Ausgangsteils auf.

Der angegebene Piezotransformator zeichnet sich durch eine hohe Durchschlagsfestigkeit bei einer geringen Baugröße aus.

Der Eingangsteil und der Ausgangsteil sind im Prinzip gegeneinander austauschbar. Sie werden als Funktionsteile des Transformators oder Transformatorteile bezeichnet.

Die Vertiefungen haben vorzugsweise einen gemeinsamen Boden, der zwischen dem Ein- und Ausgangsteil angeordnet ist. Zumindest ein Bereich des Bodens der jeweiligen Vertiefung ist vorzugsweise mit dem jeweiligen Transformatorteil verbunden.

Der Ein- und Ausgangsteil ist vorzugsweise nur mit einem Teil der Oberfläche der jeweiligen Vertiefung fest verbunden. Die erste Vertiefung hat in einer vorteilhaften Variante die Form einer Haube oder eines Bechers, dessen Wände in einem dem Becherboden zugewandten Kontaktbereich mit dem Eingangsteil fest verbunden sind. Die zweite Vertiefung hat auch die Form eines Bechers, dessen Wände in einem dem Becherboden zugewandten Kontaktbereich mit dem Ausgangsteil fest verbunden sind. Der Querschnitt des Bechers ist an die Form des jeweiligen Transformatorteils angepasst. Zwischen einem vom Boden abgewandten Randbereich der jeweiligen Vertiefung und dem Ein- und Ausgangsteil findet vorzugsweise keine feste Verbindung statt.

Der Boden und die Seitenwände der Vertiefungen werden vorzugsweise mit einer Haftschicht bedeckt, die dazu dient, eine feste Verbindung zwischen dem Isolierteil und den Funktionsteilen herzustellen. Die Haftschicht kann beispielsweise ein Epoxidharz oder einen anderen relativ harten Klebstoff umfassen.

Die Wände der ersten Vertiefung überdecken einen Teil von Außenelektroden des Eingangsteils und die Wände der zweiten Vertiefung einen Teil von Außenelektroden des Eingangsteils. Durch diese Maßnahme gelingt es, eine Kriechstrecke zwischen den Außenelektroden verschiedener Funktionsteile und somit die Durchschlagfestigkeit des Transformators zu erhöhen.

Die Dicke des zwischen den Funktionsteilen des Transformators angeordneten Bereichs des Isolierteils kann in diesem Fall unterhalb von 2 mm (beispielsweise zwischen 0,2 und 1 mm) gewählt werden, da durch die Abdeckung der Außenelektroden die für eine Entladung an der Oberfläche ausschlaggebende Kriechstrecke gegenüber dem Abstand zwischen den zueinander gewandten Kanten dieser Elektroden vergrößert werden kann. In diesem Fall eine besonders kompakte Bauform des Transformators möglich.

Die Wände der Vertiefungen bilden einen Gürtel, der den Körper umschließt und einen Teil der Außenelektroden der Transformatorteile abdeckt. Die Breite dieses Gürtels ist von der Durchschlagsfestigkeit des Materials des Isolierteils abhängig und beträgt vorzugsweise mindestens 5 mm bei einer Durchschlagfestigkeit von ca. 3 kV/mm.

Das Isolierteil umfasst einen Verbindungsbereich, der zwischen dem Ein- und Ausgangteil angeordnet ist. Das Isolierteil enthält ein Material, dessen Dielektritätskonstante ε sich von derjenigen des Materials des Ein- und Ausgangsteils unterscheidet.

Der Unterschied der Dielektritätskonstanten kann in einer Variante mindestens das Dreifache betragen. Die Dielektritätskonstante des Isolierteils kann in einer vorteilhaften Variante weniger als 10 betragen.

Dadurch, dass die Dielektritätskonstante des Isolierteils besonders niedrig gewählt ist, gelingt es, eine parasitäre kapazitive Verkopplung zwischen den Elektroden verschiedener Transformatorteile zu verringern.

Der Eingangsteil und der Ausgangsteil weisen jeweils vorzugsweise eine Vielzahl von abwechselnd angeordneten ersten und zweiten Innenelektroden auf. Die ersten Innenelektroden sind an eine erste Außenelektrode und die zweiten Innenelektroden an eine zweite Außenelektrode des jeweiligen Transformatorteils angeschlossen. Die Außenelektroden sind jeweils zumindest teilweise an der Oberfläche des Körpers angeordnet.

Das Material des Isolierteils ist vorzugsweise nicht piezoelektrisch. Der Ausdehnungskoeffizient dieses Materials ist jedoch vorzugsweise mit demjenigen des Materials des Ein- und Ausgangsteils im Wesentlichen gleich.

Das Material des Isolierteils zeichnet sich vorzugsweise durch eine hohe Durchschlagfestigkeit aus, die diejenige des Ein- und Ausgangsteils übersteigt. Der Unterschied beträgt in einer Variante mindestens das Dreifache. Das Material des Isolierteils enthält beispielsweise Keramik, die Al₂O₃ umfasst. Das Keramikmaterial des Isolierteils umfasst vorzugsweise eine LTCC. LTCC steht für Low Temperature Cofired Ceramics. Es besteht die Möglichkeit, das Isolierteil, den Eingangsteil und den Ausgangsteil gemeinsam, d. h. in einem Verfahrensschritt zu sintern.

Das Material des Isolierteils enthält alternativ einen Kunststoff. Harte Kunststoffe können von Vorteil sein. Das Isolierteil kann in einem Spritzgussverfahren erzeugt werden.

Der Transformator nutzt sowohl den direkten als auch den inversen piezoelektrischen Effekt. Unter dem direkten piezoelektrischen Effekt wird verstanden, dass in dem Grundkörper bei Auftreten von Verformungen eine Spannung abfällt. Es wird unter dem inversen piezoelektrischen Effekt verstanden, dass die piezoelektrische Keramik, die gegebenenfalls zum Einsatz des Bauelementes noch polarisiert werden muss, bei Anlegen eines elektrischen Feldes parallel oder antiparallel oder auch in einem Winkel zur Polarisierungsrichtung eine Verformung erfährt.

Der Ein- und Ausgangsteil sind vorzugsweise mechanisch aneinander gekoppelt und galvanisch voneinander getrennt. Die galvanische Trennung der beiden Teile ist durch das Isolierteil erreichbar.

Ein elektrisches Eingangssignal wird im Eingangsteil des piezoelektrischen Transformators in mechanische Schwingungen des Grundkörpers des Transformators umgewandelt. Aufgrund der mechanischen Kopplung des Eingangsteils und des Ausgangsteils sind beide Teile von der mechanischen Schwingung betroffen. Die Umwandlung der elektrischen Energie in die mechanische Energie erfolgt aufgrund des inversen piezoelektrischen Effekts. Im Ausgangsteil werden die mechanischen Schwingungen aufgrund des direkten piezoelektrischen Effekts zurück in ein elektrisches Signal verwandelt.

Mit Hilfe der Eingangselektroden wird bei Anlegen einer Spannung an den Eingangselektroden eine mechanische Verformung des Grundkörpers hervorgerufen. Mit Hilfe der Ausgangselektroden wird eine bei Verformung des Körpers auftretende elektrische Spannung abgegriffen.

Beim Anlegen einer Wechselspannung an den Eingangselektroden wird eine periodisch wiederkehrende Deformation des Körpers erzeugt. Diese periodisch wiederkehrende Deformation des Körpers ruft wiederum in den Ausgangselektroden eine sich periodisch ändernde Spannung hervor. Durch eine geeignete Anordnung der Elektroden wird eine von der Eingangsspannung unterschiedliche Ausgangsspannung erzielt. In diesem Fall erhält man einen Transformator mit einem dem Verhältnis der Spannungen entsprechenden Übersetzungsverhältnis.

Der Eingangsteil und der Ausgangsteil werden vorzugsweise jeweils durch Laminieren von keramischen Grünschichten erzeugt. Diese Schichten umfassen vorzugsweise ein Blei-Zirkonat-Titanat (PZT) oder ein anderes Material mit piezoelektrischen Eigenschaften.

Der zwischen dem Ein- und Ausgangsteil angeordnete Verbindungsbereich des Isolierteils ist vorzugsweise im Wellenknotenbereich, d. h. in einem solchen Bereich des Körpers angeordnet, in dem beim Betrieb des Transformators auftretende mechanische Schwingungen am geringsten sind.

Der angegebene Piezotransformator wird nun anhand von schematischen und nicht maßstabgetreuen Figuren erläutert. Es zeigen:
Figur 1 im Teilquerschnitt einen Piezotransformator mit einem Eingangsteil, Isolierteil und Ausgangsteil;
Figur 2 das Isolierteil in einem Querschnitt.

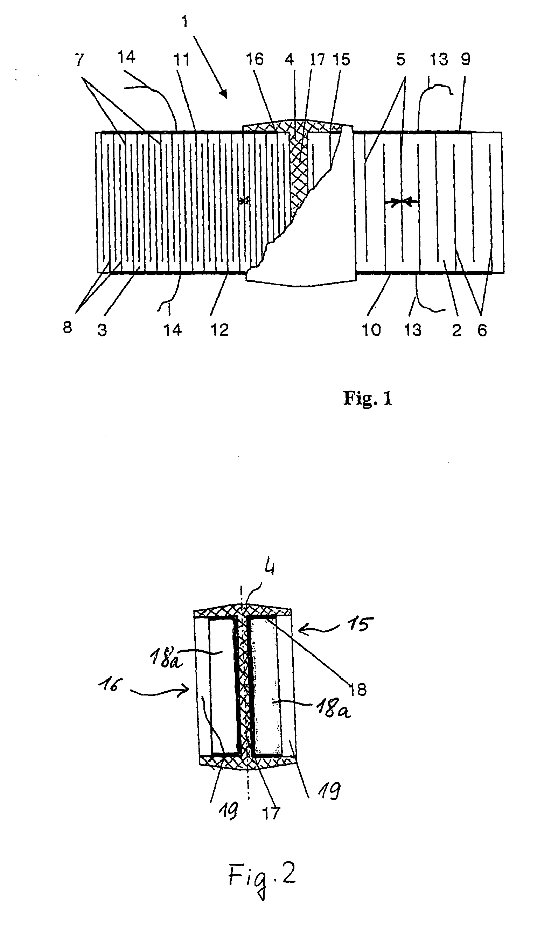

In der Figur 1 ist jeweils ein piezoelektrischer Transformator mit einem Körper 1 gezeigt. Der Transformatorkörper umfasst einen Eingangteil 2, einen Ausgangsteil 3 und ein dazwischen angeordnetes Isolierteil 4. Der Eingangteil sowie der Ausgangteil umfasst jeweils eine Vielzahl von Piezoschichten. Zwischen zwei Piezoschichten ist eine Innenelektrode des jeweiligen Teils angeordnet. Der Eingangsteil umfasst erste Innenelektroden 5, die alle an eine gemeinsame Außenelektrode 9 angeschlossen und somit leitend miteinander verbunden sind, sowie zweite Innenelektroden 6, die alle an eine gemeinsame Außenelektrode 10 angeschlossen sind. Der Ausgangsteil umfasst erste Innenelektroden 7, die alle an eine gemeinsame Außenelektrode 11 angeschlossen sind, sowie zweite Innenelektroden 8, die alle an eine gemeinsame Außenelektrode 12 angeschlossen sind. Die Außenelektroden 9, 10, 11, 12 sind an den Seitenflächen des Körpers 1 angeordnet.

Die Polarisationsrichtung der jeweiligen Piezoschicht ist mit einem Pfeil angedeutet. Die Polarisationsachse der jeweiligen Piezoschicht ist senkrecht zu den Flächen der Innenelektroden des Ein- und Ausgangsteils sowie senkrecht zu den Stirnflächen des Körpers ausgerichtet. Die Innenelektroden sind senkrecht zur Längsachse des Körpers 1 ausgerichtet.

Die Außenelektroden 9, 10 des Eingangsteils 2 sind jeweils mit einem elektrischen Anschluss 13 (beispielsweise Draht) verbunden. Die Außenelektroden 11, 12 des Ausgangsteils 3 sind jeweils mit einem elektrischen Anschluss 14 (beispielsweise Draht) verbunden.

Das Isolierteil 4 weist eine erste Vertiefung 15 zur Aufnahme des Eingangsteils 2 und eine zweite Vertiefung 16 zur Aufnahme des Ausgangsteils 3 auf. Auf der Oberfläche der Vertiefungen 15, 16 ist vorzugsweise eine Haftschicht 18 angeordnet, die zur Vermittlung der Haftung zwischen den Transformatorteilen 2, 3 und dem Isolierteil 4 dient. Ein Verbindungsbereich 17 des Isolierteils 4 ist zwischen dem Ein- und Ausgangsteil 2, 3 angeordnet. Die Dicke dieses Bereichs kann kleiner als 1 mm sein und beispielsweise im Bereich zwischen 0,3 mm und 0,8 mm liegen.

In der Figur 1 ist ein Transformator gezeigt, bei dem die Funktionsteile jeweils mehrere Piezoschichten aufweisen. Die Funktionsteile weisen in einer weiteren Variante jeweils nur eine Piezoschicht auf, die zwischen einer ersten und einer zweiten Elektrode dieses Funktionsteils angeordnet ist.

In der Figur 2 ist angedeutet, dass die Haftschicht 18 nur am Boden sowie in einem an den Boden angrenzenden Bereich 18a der jeweiligen Vertiefung 15, 16 vorgesehen ist. Die Breite des Bereichs 18a beträgt vorzugsweise maximal die Hälfte der Tiefe der Vertiefung.

Dagegen ist der Randbereich 19 der jeweiligen Vertiefung frei von der Haftschicht 18. Zwischen diesem Bereich und dem jeweiligen Transformatorteil 2, 3 besteht keine feste Verbindung und ist vorzugsweise ein enger Spalt angeordnet, so dass die Schwingungen des Körpers durch die Kopplung der Transformatorteile 2, 3 und des Isolierteils 4 nicht gedämpft werden.

### Bezugszeichenliste

- 1: Körper
- 2: Eingangsteil
- 3: Ausgangsteil
- 4: Isolierteil
- 5: erste Innenelektroden des Eingangsteils
- 6: zweite Innenelektroden des Eingangsteils
- 7: erste Innenelektroden des Ausgangsteils
- 8: zweite Innenelektroden des Ausgangsteils
- 9, 10: Außenelektroden des Eingangsteils
- 11, 12: Außenelektroden des Ausgangsteils
- 13, 14: elektrische Anschlüsse
- 15: Vertiefung zur Aufnahme des Eingangsteils
- 16: Vertiefung zur Aufnahme des Ausgangsteils
- 17: zwischen dem Ein- und Ausgangsteil angeordneter Bereich des Isolierteils
- 18: Haftschicht
- 19: Randbereich der Vertiefung

## Patentansprüche

1. Piezotransformator
- mit einem Körper (1), der einen Eingangsteil (2), einen Ausgangsteil (3) und ein Isolierteil (4) umfasst,
- wobei das Isolierteil (4) eine erste Vertiefung (15) aufweist, in der der Eingangsteil (2) angeordnet ist,
- wobei das Isolierteil (4) eine zweite Vertiefung (16) aufweist, in der der Ausgangsteil (3) angeordnet ist.

2. Piezotransformator nach Anspruch 1,
- wobei die Vertiefungen (15, 16) einen gemeinsamen Boden (17) haben, der zwischen dem Ein- und Ausgangsteil (2, 3) angeordnet ist.

3. Piezotransformator nach Anspruch 1 oder 2,
- wobei die erste Vertiefung (15) die Form eines Bechers hat, dessen Wände in einem dem Becherboden zugewandten Kontaktbereich mit dem Eingangsteil (2) fest verbunden sind,
- wobei die zweite Vertiefung (16) die Form eines Bechers hat, dessen Wände in einem dem Becherboden zugewandten Kontaktbereich mit dem Ausgangsteil (3) fest verbunden sind.

4. Piezotransformator nach einem der Ansprüche 1 bis 3,
- wobei zwischen einem vom Boden abgewandten Randbereich der jeweiligen Vertiefung (15, 16) und dem Ein- und Ausgangsteil keine feste Verbindung stattfindet.

5. Piezotransformator nach einem der Ansprüche 1 bis 4,
- wobei die Wände der ersten Vertiefung (15) einen Teil von Außenelektroden (9, 10) des Eingangsteils (2) überdecken,
- wobei die Wände der zweiten Vertiefung (16) einen Teil von Außenelektroden (11, 12) des Eingangsteils (3) überdecken.

6. Piezotransformator nach einem der Ansprüche 1 bis 5,
- wobei das Isolierteil (4) ein Material umfasst, dessen Dielektritätskonstante kleiner ist als diejenige des Materials des Ein- und Ausgangsteils (2, 3).

7. Piezotransformator nach einem der Ansprüche 1 bis 6,
- wobei ein zwischen dem Ein- und Ausgangsteil angeordneter Bereich des Isolierteils (4) im Wellenknotenbereich des Körpers angeordnet ist.

8. Piezotransformator nach einem der Ansprüche 1 bis 7,
- wobei das Isolierteil (4) als ein Gussteil ausgebildet ist.

9. Piezotransformator nach einem der Ansprüche 1 bis 8,
- wobei der Eingangsteil (2) innen liegende Eingangselektroden (5, 6) und der Ausgangsteil innen liegende Ausgangselektroden (7, 8) umfasst, die senkrecht zur Längsachse des Körpers angeordnet sind.
